# EUROPEAN PATENT APPLICATION

(11) **EP 4 783 382 A1**
(43) Date of publication of application: **29.07.2026**
(21) Application number: 25154502.6
(22) Date of filing: 28.01.2025
(51) Int. Cl.: H01S 5/50

(54) **OPTICAL AMPLIFIER**

(71) Applicant: Foundation For Research And Technology-Hellas, 700 13 Heraklion, Crete (GR)
(72) Inventor: Von Klitzing, Wolf, 700 13 Heraklion, Crete (GR)
(74) Representative: Araujo, Daniel

(57) **Abstract**

An optical amplifier comprising: a first optical fiber section (2a) that is configured to receive a light as an input (1); a fiber beam splitter (3) connected to the first optical fiber section (2a); a second optical fiber section (2b); an amplification section (9) which comprises a laser diode (7) which is optically coupled to a second end (22) of the second optical fiber section (2b) and is configured to receive the light, amplify the light, thereby producing amplified light, and transmit the amplified light towards the second end (22) of the second optical fiber section (2b); the second optical fiber section (2b) is configured to receive via its second end (22) the amplified light and direct it towards the fiber beam splitter (3); a third optical fiber section (2c) connected to the fiber beam splitter (3).

## Description

### Technical Field

The present disclosure concerns an optical amplifier. The optical amplifier may be any of an optical device, system, apparatus, configuration or assembly for amplifying light. The light may be an optical signal.

### Background

In the prior art there are known conventional optical amplifiers used for amplifying the power of light. A particular type of the known conventional optical amplifiers are the ones that utilize a laser diode which serves as a gain medium via which an optical input of the amplifier is amplified. This known conventional type of amplifiers may advantageously offer efficient light amplification and high optical power and beam quality. Consequently, this known type of amplifiers may be useful in a wide range of applications, such as for example in optical telecommunications, scientific instrumentation, experimental physics, and medical technology.

Despite their many advantages, the aforementioned known conventional optical amplifiers have some important drawbacks, in particular the following ones. These conventional amplifiers involve complex free-space optical connections and corresponding components, which may reduce the amplification efficiency of the amplifier, and result to the amplifier being complex, expensive and prone to damage and optical misalignments.

Hence, there is a need for optical amplifiers which comprise laser diodes and overcome the aforementioned drawbacks.

### Summary of the Invention

The solution provided by the present invention may advantageously allow for providing an optical amplifier which utilizes a laser diode for amplifying the light and may overcome several of the aforementioned drawbacks. Consequently, the present invention may advantageously allow for providing an optical amplifier which may advantageously be compact, efficient, robust, and exhibit very good operational stability and product lifetime. Also, at least some embodiments of the present invention may be considerably less complex and less expensive compared to the conventional ones, and offer high optical power, excellent beam quality, broad wavelength compatibility, and efficient light amplification.

The present invention in one aspect concerns an optical amplifier comprising: a first optical fiber section that is configured to receive a light as an input; a fiber beam splitter which comprises a first port via which the fiber beam splitter is connected to the first optical fiber section and is configured to receive from the first optical fiber section the light; a second optical fiber section which comprises a first end via which the second optical fiber section is connected to a second port of the fiber beam splitter and is configured to receive from the second port of the fiber beam splitter the light and transmit the light via a second end of the second optical fiber section; an amplification section which comprises a laser diode which is optically coupled to the second end of the second optical fiber section and is configured to receive the light, amplify the light, thereby producing amplified light, and transmit the amplified light towards the second end of the second optical fiber section; the second optical fiber section is further configured to receive via its second end the amplified light and direct it towards the fiber beam splitter which is configured to output at least part of the amplified light via a third port of the fiber beam splitter; a third optical fiber section connected to the third port of the fiber beam splitter. Since the optical amplifier involves the aforementioned first, second and third optical fiber sections, it may be called "fiberized", i.e. a fiberized optical amplifier.

Due to the fact the device of the first aspect invention involves the same optical fiber section, namely the second optical fiber section, for both providing to the amplification section the input light which is to be amplified, and receiving from the amplification section at least a part (i.e. portion) of the amplified light, advantageously, the device may advantageously be compact, robust and operationally stable and efficient. This advantage of the amplifier according to the invention is related to the device's aforementioned configuration which is substantially less complex and easier to assemble compared to the configurations of several of the conventional amplifiers of the prior art, and involves the use of the first, second and third optical fiber sections, the fiber beam splitter, and the laser diode. The aforementioned configuration of the device of the present invention may advantageously allow for the device to exhibit a good, robust, stable and highly versatile operation which may in turn be leveraged for the efficient use of the device in a variety of different applications such as in quantum technologies, experimental physics, optical communications, imaging, laser cooling and trapping in atomic physics, quantum optics, quantum sensing, quantum information, telecommunications or in other applications.

In a very preferred embodiment of the invention, hereafter referred to as "first exemplary embodiment", the amplification section comprises a Faraday rotator which is optically coupled to the second end of the second optical fiber section and is configured to receive from the latter the light, apply a first polarization rotation to the light, and subsequently transmit the light to the laser diode; and the Faraday rotator is also optically coupled to the laser diode and is further configured to receive from the laser diode the amplified light, apply to the amplified light a second polarization rotation and subsequently transmit the amplified light to the second end of the second fiber section. This Faraday rotator is an optional component which may advantageously increase the portion (i.e. the part) of the amplified light that is eventually coupled into, and output by, the third optical fiber section during an operation of the device. For this purpose, more preferably, in addition to including in the amplifier the aforementioned Faraday rotator, the fiber beam splitter is also polarizing. The optional yet preferable option of the amplifier's fiber beam splitter being polarizing and be used in combination with the aforementioned Faraday rotator be included in the device, may result to substantially optimizing and increasing the intensity of the output signal that can be provided by the amplifier. Also, it may be understood that, overall, the Faraday rotator is an optional element that may advantageously improve the quality of an output signal of the amplifier via changing the polarization of at least some of the light being provided to the laser diode, and also changing the polarization of the amplified light, compared to the polarization of the light that is inputted to the amplifier via the latter's first optical fiber section. Overall, in the first exemplary embodiment, the use of the Faraday rotator may offer several advantages, particularly the following ones: prevent back-reflection damage via blocking back-reflected light, protecting the laser diode from optical feedback that could destabilize or damage the device; maintain stable operation, via eliminating feedback-induced interference, for ensuring stable and consistent amplification performance; preserve beam quality, via avoiding distortions caused by unwanted reflections, maintaining the beam's coherence and quality; enhance system reliability via reducing the impact of feedback, thereby improving the longevity and reliability of the amplifier in high-precision applications. Moreover, the Faraday rotator may advantageously be utilized for ensuring compatibility of the polarization state of the of the amplifier's output signal with any potentially present downstream optical components or subsequent optical processing steps.

In a preferred embodiment which is according to the aforementioned first exemplary embodiment, each of the first and second polarization rotations is a rotation by approximately 45 degrees. This may advantageously further optimize the aforementioned operational improvements that may be offered by the optional yet preferable presence in the amplifier of the Faraday rotator. Hence, it may be understood that the Faraday rotator may preferably be configured to cause that the polarization of the amplified light that is transmitted from the amplification stage to the fiber beam splitter is rotated by a total of 90 degrees compared to the polarization of the light that is inputted to the amplifier via the first optical fiber section. Hence, in a preferred embodiment which is according to the first exemplary embodiment, a polarization of the amplified light received by the second optical fiber section from the Faraday rotator is rotated by approximately 90 degrees compared to a polarization of the input received by the first optical fiber section.

In a preferred embodiment which is according to the first exemplary embodiment, the Faraday rotator comprises a first port and a second port which are on opposite sides of the Faraday rotator; the first port of the Faraday rotator is optically coupled to the second end of the second fiber section; the second port of the Faraday rotator is optically coupled to the laser diode. In the latter embodiment, the respective optical couplings of the Faraday rotator with the second end of the second optical fiber section and with the laser diode, may advantageously reduce optical losses in the amplifier, and improve the overall operational efficiency of the amplifier. For this reason, and for facilitating the aforementioned optional couplings of the Faraday rotator to the second fiber section and to the laser diode, in some preferred embodiments which are according to the previous one, the amplification section further comprises: first coupling means configured to optically couple the first port of the Faraday rotator to the second end of the second optical fiber section; and/or second coupling means configured to optically couple the second port of the Faraday rotator to the laser diode.

Preferably, any of the aforementioned first coupling means and second coupling means comprised at least one corresponding lens.

In a very preferred embodiment of the invention, hereafter referred to as "second exemplary embodiment", the laser diode comprises a first side and a second side, the first side and the second side being opposite sides of the laser diode, and the laser diode is configured to receive via the first side the light to be amplified; the laser diode is further configured to produce the amplified light via transmitting the light from the first side towards the second side and backwards, when the laser diode is in operation. In the latter embodiment, the laser diode may advantageously act as a double-pass gain medium which may contribute to increasing and optimizing the amplification and maximum output power that may be achieved with the amplifier. It may be understood that the term "double pass" refers to the light successively traveling inside the diode along two opposite directions, firstly in a first direction from the first side towards the second side of the laser diode, and subsequently in a second direction from the second side towards the first side of the laser diode. Hence, in a very preferred embodiment of the invention, the laser diode is, i.e. acts as, a double pass laser diode.

In a preferred embodiment which is according to the second exemplary embodiment, the amplification section further comprises a mirror; the second side of the laser diode comprises an optical aperture for transmitting towards the mirror at least some of the light transmitted from the first side to the second side; and the mirror is configured to reflect backwards towards the optical aperture of the second side at least some of the light transmitted from the second side to the mirror. The use of this optional mirror may further facilitate the aforementioned double pass operation of the diode, and contribute to further optimizing the operational stability and efficiency of the amplifier. It is noted that preferably the aforementioned mirror is flat or is curved, and more preferably the mirror is optically coupled to the second side of the laser diode via at least one lens of the amplification section. In the latter configuration the lens may advantageously contribute to reducing or avoiding optical losses in the amplification section.

In a preferred embodiment of the invention, the laser diode is a tapered laser diode amplifier. More preferably the laser diode is a double pass tapered amplifier (i.e. a double pass tapered laser diode amplifier). The use of laser diode that functions as a tapered amplifier, especially a double pass tapered amplifier, for amplifying the light, may advantageously contribute to further improving the maximum achievable power of the amplifier's output, and to optimizing the amplifier's amplification efficiency, operational stability and output quality.

In a preferred embodiment of the invention, the amplification section further comprises at least one optical coupling element for optically coupling the laser diode to the second end of the second optical fiber section. The optical coupling element which preferably is a coupling lens is an optional feature that may advantageously further optimize the performance of the amplifier via facilitating and improving the optical coupling between the second optical fiber section and the laser diode.

Preferably any or all of the aforementioned optical fiber sections may consist of or comprise one or more corresponding optical fibers. Especially, the first optical fiber section may preferably be, i.e. consist of, a first optical fiber. Similarly, the second optical fiber section may preferably be, i.e. consist of, a second optical fiber. Also, the third optical fiber section may preferably be, i.e. consist of, a third optical fiber. However, it is noted that any of the aforementioned optical fiber sections may comprise additional optical components. For example, in an embodiment which is according to the aforementioned first exemplary embodiment, the Faraday rotator is directly connected to the second optical fiber section.

In a preferred embodiment of the invention, the fiber beam splitter is polarizing. The optional use of a polarizing fiber beam splitter may advantageously allow for precisely and efficiently managing light based on polarization, and for optimizing the design and performance of the device. Also, as described further above, the optional use of a polarizing beam splitter may optimize or even maximize the amount of light that is eventually sent to (i.e. directed or coupled into), and can be extracted via, the third optical fiber section during an operation of the device. Moreover, the optional use of a polarizing beam splitter may advantageously help to minimize the amount of light needed to get a specific output power, or equivalently help to increase the amount of amplification (as a ratio of input to output power) that can be achieved. Also, the polarizing fiber beam splitter may exhibit a high extinction ratio, low insertion loss, and good versatility, and these qualities may be utilized for further improving the potential application of the device in a variety of modern optical systems, from telecommunications to advanced quantum technologies.

In a preferred embodiment of the invention, the fiber beam splitter is a beam splitter Faraday rotator. In the latter case, the beam splitter Faraday rotator may advantageously offer the aforementioned functionalities of both the fiber beam splitter and of the Faraday rotator mentioned further above in relation to the first exemplary embodiment of the invention. Also, compared to the aforementioned first exemplary embodiment, the use in the amplifier of a component which acts as both a beam splitter and as a Faraday rotator may advantageously significantly simplify the overall structure of the amplifier, and may further improve the operational stability, robustness and optical output quality of the amplifier.

In a preferred embodiment of the invention, the laser diode is directly connected, i.e. directly matched, to the second end of the second optical fiber section. In the latter case, the optical coupling of the laser diode to the second optical fiber section is achieved via a physical connection/contact of the laser diode to the second end of the second optical fiber section, and this physical connection may be a direct one, or an indirect one e.g. via an adapter. This may advantageously allow for reducing or completely eliminating the number of free-space optical connections in the amplifier, which may in turn allow for reducing the amplifier's optical losses, and for further optimizing the performance and robustness of the amplifier.

Additional advantages and features of the invention will become apparent from the detailed description that follows and will be particularly pointed out in the appended claims.

### Brief Description of Drawing

Fig. 1 illustrates a schematic diagram of a preferred embodiment of the invention.
Fig. 2 illustrates a schematic diagram of part of the embodiment of Fig. 1.
Fig. 3 illustrates a schematic diagram of a preferred embodiment of the invention.
Fig. 4 illustrates a schematic diagram of a preferred embodiment of the invention.
Fig. 5 illustrates a schematic diagram of a preferred embodiment of the invention.
Fig. 6 illustrates a schematic diagram of a preferred embodiment of the invention.
Fig. 7 illustrates a schematic diagram of a preferred embodiment of the invention.
Fig. 8 illustrates a schematic diagram of a preferred embodiment of the invention.

### Detailed Description

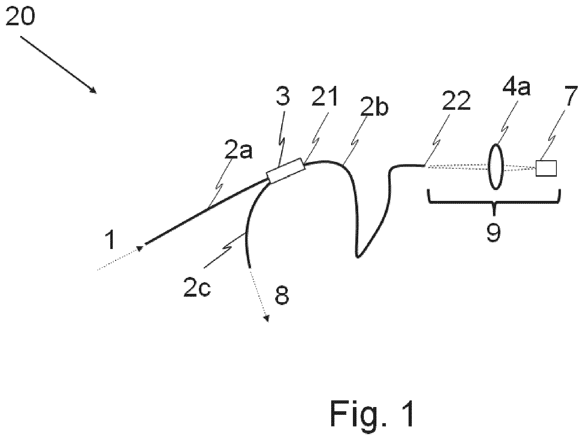

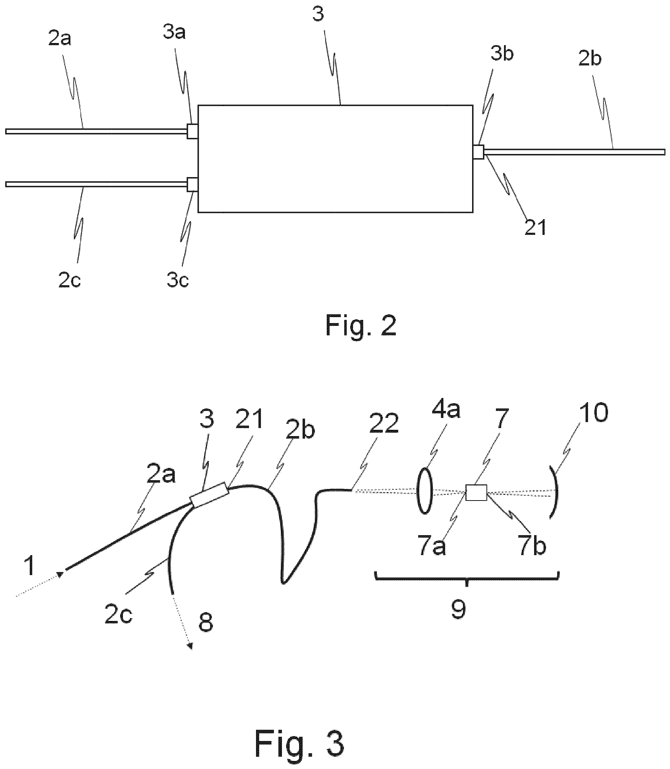

A preferred embodiment of the first aspect of the invention is explained next with reference to Fig. 1 and Fig. 2 which schematically illustrate an optical amplifier 20. The amplifier 20 comprises a first optical fiber section 2a, a fiber beam splitter 3, a second optical fiber section 2b, an amplification section 9 and a third optical fiber section 2c. The amplification section 9 comprises a laser diode 7. The first optical fiber section 2a is configured to receive light which is an optical input 1 to the device. The fiber beam splitter 3 comprises a first port 3a via which the fiber beam splitter 3 is connected to the first optical fiber section 2a and is configured to receive from the latter the light. Hence, the first optical fiber section 2a is connected to the first port 3a for providing to the fiber beam splitter 3 at least part of the optical input 1. The second optical fiber section 2b comprises a first end 21 which via a second port 3b of the fiber beam splitter 3 is connected to the latter and is configured to receive the light. Also, the second optical fiber section 2b via a second end 22 of it is configured to transmit at least some of the light it receives from the beam splitter 3. It is noted that the fiber beam splitter may optionally have more than three ports, e.g. may optionally have four or more ports. The laser diode 7 is optically coupled to the second end 22 of the second optical fiber section 2b and is configured to receive from the second end 22 the light, and to amplify the latter (i.e. the received light), thereby producing amplified light, and transmit the amplified light towards the second end 22 of the second optical fiber section 2b. The second optical fiber section 2b is further configured to receive via its second end 22 the amplified light and direct it towards the fiber beam splitter 3 which is configured to output at least part of the amplified light via a third port 3c of the fiber beam splitter 3. Therefore, the second optical fiber section 2b serves for both providing to the amplification section 9 the light which is to be amplified, and for receiving from the amplification section 9 at least part of the amplified light. Moreover, the second optical fiber section 2b is further configured to receive the transmitted amplified light, i.e. the amplified light that is coupled into the second optical fiber section 2b, and direct it towards the fiber beam splitter 3. The latter is configured to receive the transmitted amplified light and output at least part of the latter via a third port 3c of the fiber beam splitter 3. This amplified light that is outputted via the third port 3c of the fiber beam splitter 3 can become an output signal 8 that the device can provide via the third optical fiber section 2c which is connected to the third port 3c of the fiber beam splitter 3.

Moreover, in the amplifier 20 of Fig. 1, the amplification section 9 comprises an optical coupling element 4a which is configured to optically couple the laser diode 7 to the second end 22 of the second optical fiber section 2b. More specifically, in the embodiment of Fig. 1 the optical coupling element 4d is a coupling lens. It is noted that in Fig. 1-7 the dashed lines in the amplification section are ray-trace lines which schematically illustrate a path of the light travelling along the amplification section 9 during an operation of the respective embodiment in each case.

Another preferred embodiment of the invention is illustrated by Fig. 3. The embodiment of Fig. 3 is similar to the one of Fig. 1, with one difference being that in the embodiment of Fig. 3 the amplification section 9 further comprises a mirror 10 which is a curved mirror. Also, in the embodiment of Fig. 3 the laser diode 7 comprises a first side 7a and a second side 7b, wherein the first side 7a and the second side 7b are opposite sides of the laser diode. In the embodiment of Fig. 3 the laser diode 7 is configured to receive via the first side 7a the light to be amplified. Moreover, the laser diode 7 is further configured to produce the amplified light via transmitting the light from the first side 7a towards the second side and backwards, when the laser diode 7 is in operation. Also, in the embodiment of Fig. 3, the second side 7b of the laser diode 7 comprises an optical aperture for transmitting towards the mirror (10) at least some of the light transmitted from the first side 7a to the second side 7b. Also, the mirror 10 is configured to reflect backwards towards the optical aperture of the second side 7b at least some of the light transmitted from the second side 7b to the mirror 10.

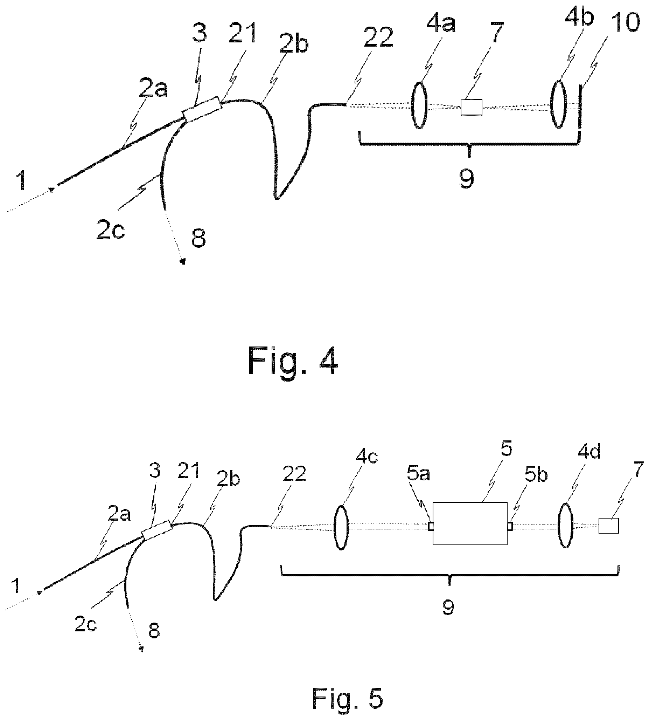

Another preferred embodiment of the invention is illustrated by Fig. 4. The embodiment of Fig. 4 is similar to the one of Fig. 3. However, the embodiment of Fig. 4 differs compared to the one of Fig. 3 in that in the embodiment of Fig. 4 the mirror 10 is flat, and the amplification section further comprises a lens 4b via which the mirror 10 is optically coupled to the second side 7b of the laser diode 7.

Another preferred embodiment of the invention is illustrated by Fig. 5 and is according to the aforementioned first exemplary embodiment. The embodiment of Fig. 5 is similar to the one of Fig. 1, however the part of the amplification section 9 between the second optical fiber section 2b and the diode is different in the embodiment of Fig. 5 compared to the one of Fig. 1. Specifically, in the embodiment of Fig. 5 the amplification section 9 comprises a Faraday rotator 5 which is optically coupled to the second end 22 of the second optical fiber section 2b and is configured to receive from the latter the light, apply a first polarization rotation to the light, and subsequently transmit the light to the laser diode 7. Also, in the embodiment of Fig. 5 the Faraday rotator 5 is optically coupled to the laser diode 7 and is further configured to receive from the laser diode 7 the amplified light, apply to the amplified light a second polarization rotation and subsequently transmit the amplified light to the second end 22 of the second fiber section 2b. It is noted that in the embodiment of Fig. 5, the Faraday rotator 5 comprises a first port 5a (i.e. a first optical port) and a second port 5b (i.e. a second optical port) which are on opposite sides of the Faraday rotator 5. The first port 5a of the Faraday rotator 5 of the embodiment of Fig. 5 is optically coupled to the second end 22 of the second fiber section 2b, whereas the second port 5b of the Faraday rotator 5 is optically coupled to the laser diode 7. Also, in the embodiment of Fig. 5 the amplification section 9 further comprises first coupling means 4c and second coupling means 4d. In the embodiment of Fig. 5 the first coupling means 4c is a respective first lens which is configured to optically couple the first port 5a of the Faraday rotator 5 to the second end 22 of the second optical fiber section 2b, and the second coupling means 4d is a respective second lens configured to optically couple the second port 5b of the Faraday rotator 5 to the laser diode 7.

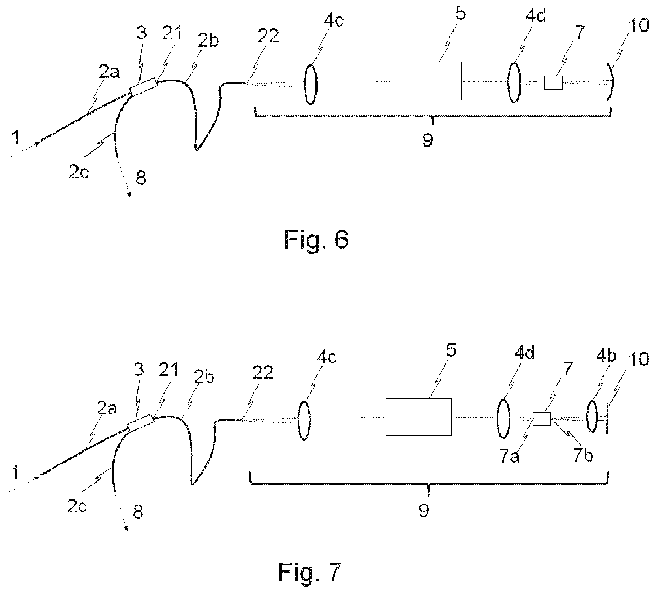

Another preferred embodiment of the invention is illustrated by Fig. 6. The embodiment of Fig. 6 is similar to the one of Fig. 5, with the difference being that in the embodiment of Fi. 6 the amplification section 9 comprises a curved mirror 10 similarly to the embodiment of Fig. 3.

Another preferred embodiment of the invention is illustrated by Fig. 7. The embodiment of Fig. 7 is similar to the one of Fig. 6, with a difference being that in the embodiment of Fig. 7 the mirror is not curved but instead is flat, and between the flat mirror 10 and the laser diode 7 there is a lens 4b for coupling the mirror 10 to the second side 7b of the diode laser, similarly to the embodiment of Fig. 4.

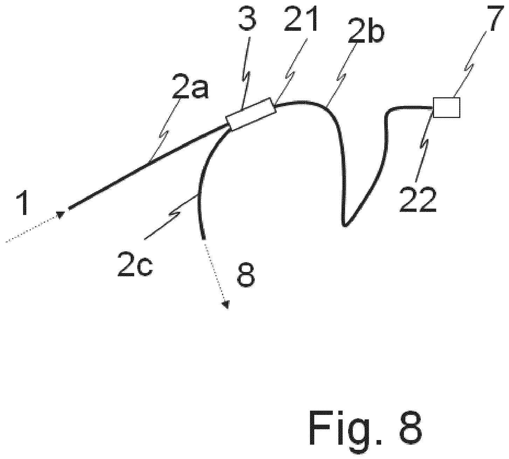

Another preferred embodiment of the invention is illustrated by Fig. 8. The embodiment of Fig. 8 is similar to the one of Fig. 1, with a difference being that in the embodiment of Fig. 8 the laser diode 7 is directly connected (i.e. directly matched) to the second end 22 of the second optical fiber section 2b.

In this text, the term "comprises" and its derivations (such as "comprising", etc.) should not be understood in an excluding sense, that is, these terms should not be interpreted as excluding the possibility that what is described and defined may include further elements, steps, etc.

While the foregoing is directed to embodiments of the present invention, other and further embodiments of the invention may be devised without departing from the basic scope thereof. Those skilled in the art will understand that the embodiments disclosed here are non-limitative examples, and other embodiments are possible.

## Claims

1. An optical amplifier comprising:
a first optical fiber section (2a) that is configured to receive a light as an input (1);
a fiber beam splitter (3) which comprises a first port (3a) via which the fiber beam splitter (3) is connected to the first optical fiber section (2a) and is configured to receive from the latter the light;
a second optical fiber section (2b) which comprises a first end (21) via which the second optical fiber section (2b) is connected to a second port (3b) of the fiber beam splitter (3) and is configured to receive from the second port (3b) of the fiber beam splitter (3) the light and transmit the light via a second end (22) of the second optical fiber section (2b);
an amplification section (9) which comprises a laser diode (7) which is optically coupled to the second end (22) of the second optical fiber section (2b) and is configured to receive the light, amplify the light, thereby producing amplified light, and transmit the amplified light towards the second end (22) of the second optical fiber section (2b);
the second optical fiber section (2b) is further configured to receive via its second end (22) the amplified light and direct it towards the fiber beam splitter (3) which is configured to output at least part of the amplified light via a third port (3c) of the fiber beam splitter (3);
a third optical fiber section (2c) connected to the third port (3c) of the fiber beam splitter (3).

2. An optical amplifier according to claim 1, wherein the amplification section (9) comprises a Faraday rotator (5) which is optically coupled to the second end (22) of the second optical fiber section (2b) and is configured to receive from the latter the light, apply a first polarization rotation to the light, and subsequently transmit the light to the laser diode (7); and the Faraday rotator (5) is also optically coupled to the laser diode and is further configured to receive from the laser diode (7) the amplified light, apply to the amplified light a second polarization rotation and subsequently transmit the amplified light to the second end (22) of the second fiber section (2b).

3. An optical amplifier according to claim 2, wherein each of the first and second polarization rotations is a rotation by 45 degrees.

4. An optical amplifier according to any of claims 2-3, wherein a polarization of the amplified light received by the second optical fiber section (2b) from the Faraday rotator (5), is rotated by 90 degrees compared to a polarization of the input (1) received by the first optical fiber section (2b).

5. An optical amplifier according to any of claims 2-4, wherein the Faraday rotator (5) comprises a first port (5a) and a second port (5b) which are on opposite sides of the Faraday rotator (5);
the first port (5a) of the Faraday rotator (5) is optically coupled to the second end (22) of the second fiber section (2b);
the second port (5b) of the Faraday rotator (5) is optically coupled to the laser diode (7).

6. An optical amplifier according to claims 5, wherein the amplification section (9) further comprises: first coupling means (4c) configured to optically couple the first port (5a) of the Faraday rotator (5) to the second end (22) of the second optical fiber section (2b); and/or second coupling means (4d) configured to optically couple the second port (5b) of the Faraday rotator (5) to the laser diode (7).

7. An optical amplifier according to claim 6, wherein any of the first coupling means (4c) and the second coupling means (4d) comprise at least one corresponding lens.

8. An optical amplifier according to any of the preceding claims, wherein:
the laser diode (7) comprises a first side (7a) and a second side (7b), the first side (7a) and the second side (7b) being opposite sides of the laser diode, and the laser diode (7) is configured to receive via the first side (7a) the light to be amplified;
the laser diode (7) is further configured to produce the amplified light via transmitting the light from the first side (7a) towards the second side and backwards, when the laser diode (7) is in operation.

9. An optical amplifier according to claim 8, wherein the amplification section (9) further comprises a mirror (10); the second side (7b) of the laser diode (7) comprises an optical aperture for transmitting towards the mirror (10) at least some of the light transmitted from the first side (7a) to the second side (7b); and the mirror (10) is configured to reflect backwards towards the optical aperture of the second side (7b) at least some of the light transmitted from the second side (7b) to the mirror (10).

10. An optical amplifier according to claim 9, wherein the mirror (10) is flat or is curved.

11. An optical amplifier according to any of claims 9-10, wherein the mirror (10) is optically coupled to the second side (7b) of the laser diode (7) via at least one lens (4b) of the amplification section (9).

12. An optical amplifier according to any of the preceding claims, wherein the fiber beam splitter (3) is polarizing.

13. An optical amplifier according to any of the preceding claims, wherein the fiber beam splitter (3) is a beam splitter Faraday rotator.

14. An optical amplifier according to any of the preceding claims, wherein the laser diode (7) is a tapered laser diode amplifier, preferably a double pass tapered laser diode amplifier.

15. An optical amplifier according to any of the preceding claims, wherein the amplification section (9) comprises at least one optical coupling element (4a) for optically coupling the laser diode (7) to the second end (22) of the second optical fiber section (2b), preferably the optical coupling element (4a) being a coupling lens.
